# EUROPEAN PATENT SPECIFICATION

(11) **EP 3 401 938 B1**
(45) Date of publication and mention of the grant of the patent: **19.01.2022**
(21) Application number: 16883856.3
(22) Date of filing: 27.12.2016
(51) Int. Cl.: H01G 9/20

(54) **PHOTOVOLTAIC ELEMENT**
FOTOVOLTAIKMODUL
ÉLÉMENT PHOTOVOLTAÏQUE

(30) Priority: 06.01.2016 JP 2016001278
(43) Date of publication of application: 14.11.2018
(60) Divisional application: 20191884.4
(73) Proprietor: International Frontier Technology Laboratory Inc., Tokyo 105-0001 (JP)
(72) Inventor: KOMATSU, Nobuaki, Tokyo 105-0001 (JP); ITO, Tomoko, Tokyo 105-0001 (JP)
(74) Representative: Ter Meer Steinmeister & Partner
(86) International application number: PCT/JP2016/088848
(87) International publication number: WO 2017/119357

(56) References cited:
- EP-A1- 2 421 084
- EP-A1- 2 453 266
- EP-A1- 2 685 554
- EP-A2- 1 936 644
- WO-A1-2012/124656
- JP-A- 2007 018 809
- JP-A- 2008 257 893
- JP-A- 2012 234 693
- JP-A- 2013 161 775
- US-A1- 2009 133 741
- US-A1- 2009 293 947
- US-A1- 2014 096 813
- PONKEN TANACHAI ET AL: "Preparation of fuorine-doped tin oxide (FTO) template for coated platinum (Pt) layer counter electrode by electrochemical method for dye-sensitized solar cell application", 2015 INTERNATIONAL CONFERENCE ON SCIENCE AND TECHNOLOGY (TICST), IEEE, 4 November 2015 (2015-11-04), pages 528-532, XP032839217, DOI: 10.1109/TICST.2015.7369411 [retrieved on 2015-12-30]

## Description

### [Technical Field]

The present invention relates to photovoltaic elements.

### [Background Art]

So-called solar cells and various other types of elements and devices have been devised as photovoltaic elements that convert optical energy into electric energy. The photovoltaic elements are roughly classified into two; those using silicon-based material and those using compound-based material as the material for exerting photovoltaic effect.

Elements that use monocrystalline silicon, polycrystalline silicon, heterojunction model, amorphous silicon and thin-film polycrystalline silicon are typical examples of elements that use silicon-based material. Meanwhile, elements using group III-V compounds, CIS (using copper (Cu), indium (In) and selenium (Se) as main components), CIGS (using copper (Cu), indium (In), gallium (Ga) and selenium (Se) as main components), CdTe, organic thin film and dye-sensitized material are examples of elements that use compound-based material.

In addition to the above-described photovoltaic elements, there are elements using silicon dioxide, which is an insulator, as power generating material. This is based on a finding by the present inventors that silicon dioxide itself exerts photo electrolysis effect and photovoltaic effect.

The present inventors have found that synthetic quartz and fused quartz, which are silicon dioxides, exert photovoltaic effect, and proposed a silicon dioxide solar cell as photoelectrode material and photocell material (Patent Literatures 1 and 2).

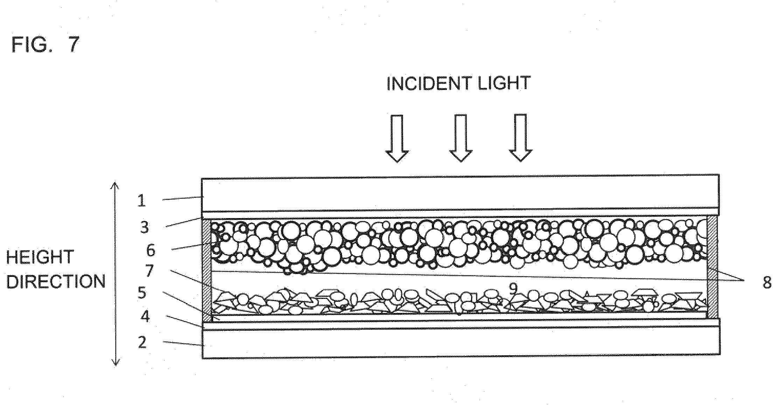

With reference to FIG. 7, we will describe a tandem-type power generation element using two photovoltaic layers formed of silicon dioxide (SiO₂) and titanium oxide (TiO₂) as a prior art example.

US 2009/293947 A1 discloses a photoelectric transducer comprising a light transparent substrate, a light transparent conductive layer provided on the light transparent substrate and a porous semiconductor layer provided on the light transparent conductive layer. The porous semiconductor layer can absorb coloring matter and contains an electrolyte. The photoelectric transducer further comprises a porous spacer layer containing an electrolyte provided on the porous semiconductor layer and a counter electrolyte layer provided on the porous spacer layer.

US 2009/133741 A1 discloses a photoelectric conversion device comprising a laminated body comprising a conducting substrate and an opposing electrode layer, a porous spacer layer containing an electrolyte, a porous semiconductor layer that absorbs a dye and contains the electrolyte and a light transmitting conductive layer respectively laminated in this order on the conducting substrate.

US 2014/096813 A1 discloses a photoelectric conversion element including a transparent substrate, a transparent conductive layer arranged on the transparent substrate, a photoelectric conversion layer arranged on the transparent conductive layer, a porous insulating layer arranged in contact with the photoelectric conversion layer, a reflective layer arranged in contact with the porous insulating layer, and a catalyst layer and a counter conductive layer that are arranged on the reflective layer.

EP 2 453 266 A1 discloses a dye-sensitized solar cell including a first electrode, a light absorption layer disposed on one side of the first electrode, a second electrode facing the first electrode, a light reflecting layer disposed on one side of the second electrode, and an electrolyte filled between the first electrode and the second electrode. The light reflecting layer includes a plurality of thin films including a first oxide thin film and a second oxide thin film, the first oxide thin film has a different reflective index from the second oxide thin film, and the first and second oxide thin films are stacked alternatively. EP 2 685 554 A1 discloses a silicon dioxide solar cell and a tandem solar cell comprising silicon dioxide and dye sensitized TiO₂, separated by a membrane.

In FIG. 7, reference numbers 1 and 2 denote glass substrates, and 3 and 4 denote FTO (fluorine-doped tin oxide) layers.

A porous titanium dioxide layer 6 hardened by sintering is formed on the FTO layer 3 on the side from which incident light enters. The porous titanium dioxide layer 6 carries titania particles on which are adsorbed ruthenium complex dye as sensitized dye. Further, a platinum film 5 is formed on the FTO layer 4.

A silicon dioxide layer 7 composed of silicon dioxide particles is formed on the platinum film 5, so that the layer 7 has a thickness of 0.15 - 0.20 mm in the height direction.

Moreover, the distance between the titanium dioxide layer 6 and the silicon dioxide layer 7 in the height direction is 0.2 mm or greater, and electrolyte 9 is sealed in a space surrounded on four sides by a sealing member 8.

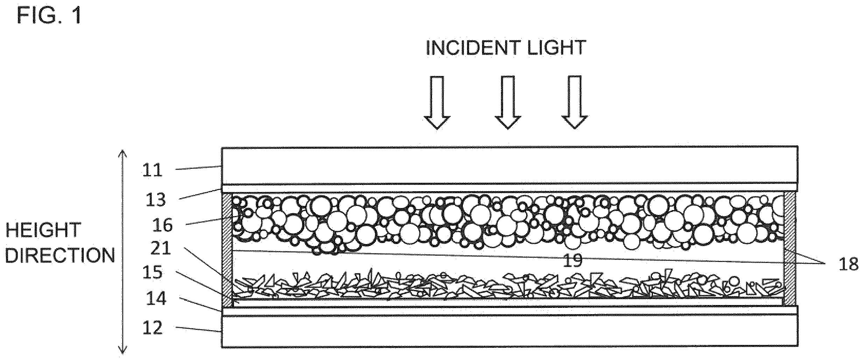

As illustrated in FIGs. 1, 2, 4 and 7, the direction perpendicular to the substrate surface of the photovoltaic element is referred to as the height direction, and thickness of layers and films is described by the distance thereof,

The silicon dioxide layer 7 serving as the photovoltaic layer is composed of silicon dioxide particles, which are formed by immersing particles of glass and the like containing silicon dioxide in a 5 - 10 % hydrofluoric solution, washing the particles with water, drying, and pulverizing the same so that the particle size is 0.2 mm or smaller.

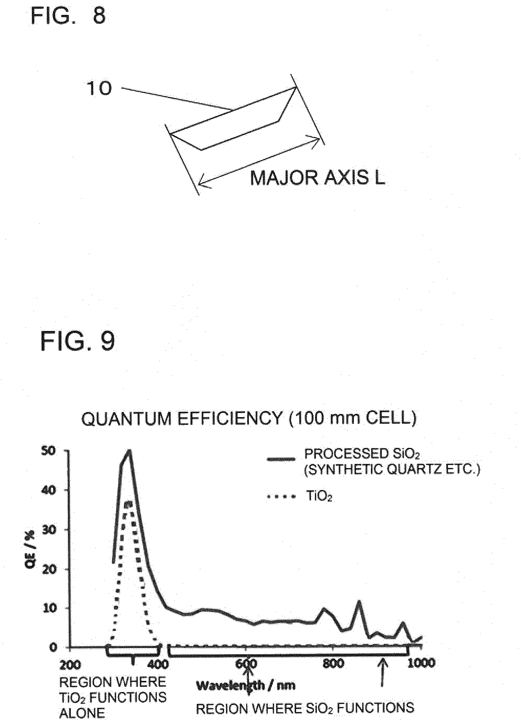

As described, individual shapes of the pulverized silicon dioxide particles may be approximately spherical, but nonspherical particles as illustrated in FIG. 8 also exist.

The individual silicon dioxide particles 10 have various shapes. In the present specification, as illustrated in FIG. 8, a maximum elongation direction of the individual silicon dioxide particles 10 is referred to as a major axis L, and the average major axis is used to denote the shape of the silicon dioxide particles used in the photovoltaic layer and a first photovoltaic layer 17. In the prior art example illustrated in FIG. 7, a material having an average major axis L of 500 - 800 nm is used.

The tandem-type photovoltaic element described here characterizes in using silicon dioxide as the photovoltaic layer. As illustrated in FIG. 9, it is confirmed that silicon dioxide has higher quantum efficiency than titanium dioxide even in the ultraviolet region, and that it also absorbs light in the infrared region of 2500 nm and higher. Therefore, silicon dioxide exerts photovoltaic effect in a wider wavelength region compared to titanium dioxide and realizes an extremely high power generation efficiency. According to such tandem-type photovoltaic element, the inventors of the present invention have achieved a maximum output of 28.00 µW/cm² per unit area in an illumination of 1000 lux.

### [Citation List]

### [Patent Literature]

[PTL 1] International Publication of International Patent Application WO 2011/049156 A1
[PTL 2] International Publication of International Patent Application WO 2012/124655 A1

### [Summary of Invention]

### [Technical Problem]

The photovoltaic elements disclosed in PTL 1 and PTL 2 can be manufactured using a low-cost material compared to prior art solar cells, and the energy conversion effect thereof is extremely high compared to other photovoltaic elements. However, even further enhancement of energy conversion effect is desired in photovoltaic elements.

### [Solution to Problem]

According to the claimed invention, a photovoltaic element for solving the above-described problem, comprises a first photovoltaic layer composed of a silicon dioxide particle that has an average major axis of 100 nm or smaller, and wherein a thickness of the first photovoltaic layer in a height direction is formed to be smaller than three times the average major axis of the silicon dioxide particle.

### [Advantageous Effects of Invention]

The photovoltaic element described above significantly improves the power generation output per unit area compared to the prior art photovoltaic element.

The problems, configurations and effects other than those described above will become apparent from the following description of embodiments.

### [Brief Description of Drawings]

[FIG. 1] FIG. 1 is a cross-sectional view of a tandem-type photovoltaic element according to a first embodiment, not forming part of the claimed invention.
[FIG. 2] FIG. 2 is a cross-sectional view of a tandem-type photovoltaic element according to a second embodiment.
[FIG. 3] FIG. 3 is an enlarged view of portion A of FIG. 2.
[FIG. 4] FIG. 4 is a cross-sectional view of a tandem-type photovoltaic element according to a third embodiment.
[FIG. 5] FIG. 5 is an enlarged view of portion B of FIG. 4.
[FIG. 6] FIG. 6 is a schematic diagram in which a first conductive film according to the third embodiment is illustrated from bird's eye view.
[FIG. 7] FIG. 7 is a cross-sectional view of a tandem-type photovoltaic element according to a comparative example.
[FIG. 8] FIG. 8 is a view illustrating an example of a silicon dioxide particle.
[FIG. 9] FIG. 9 is a measurement chart of quantum efficiency of the photovoltaic element composed of TiO₂ and the photovoltaic element including SiO₂ in a light wavelength region.

### [Description of Embodiments]

Now, preferred embodiments of the present invention will be described with reference to the drawings. At first, matters common to the first, second and third embodiments are described.

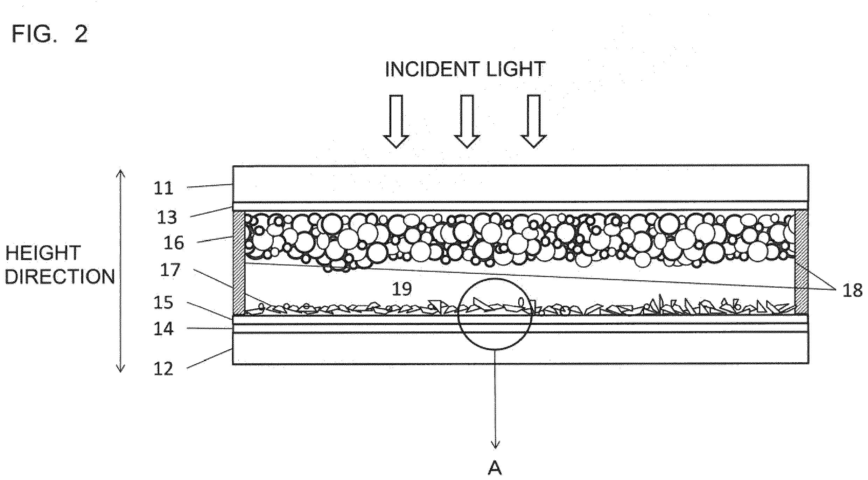

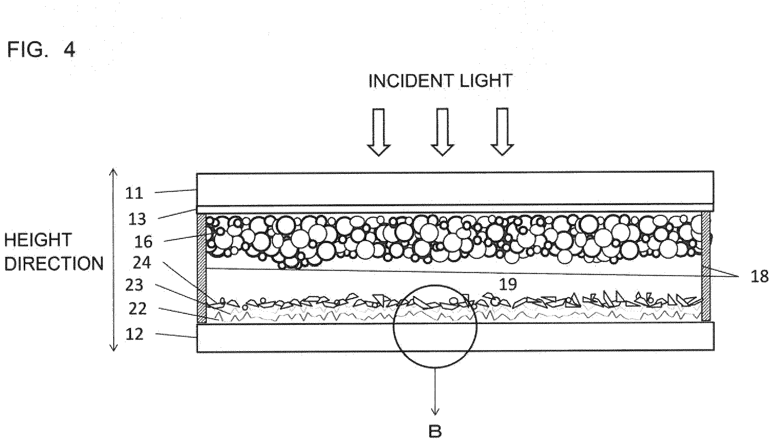

FIG. 1 is a tandem-type photovoltaic element according to a first embodiment, not forming part of the claimed invention. FIG. 2 is a cross-sectional view of a tandem-type photovoltaic element according to a second embodiment, and FIG. 4 is a cross-sectional view of a tandem-type photovoltaic element according to a third embodiment, wherein matters described below are common to FIGs. 1, 2 and 4, so they are described with reference to FIG. 1 as the representative drawing.

FIGs. 1, 2 and 4 all illustrate a tandem-type photovoltaic element comprising two photovoltaic layers, which are a first photovoltaic layer and a second photovoltaic layer.

In FIG. 1, among a first substrate 12 and a second substrate 11, at least the second substrate arranged on a side from which incident light enters is composed of a transparent material, and preferably, both substrates are composed of transparent material. Glass is a popular transparent material, but resin, such as plastic, can be used instead of glass.

A transparent second conductive film 13 is formed on the second substrate. The second conductive film 13 is preferably composed of FTO (fluorine-doped tin oxide), but other than the FTO layer, an indium-tin complex oxide (IOT) may be used, for example.

A second photovoltaic layer 16 is formed on the second conductive film 13. A typical example of the second photovoltaic layer 16 is an oxide semiconductor layer, and specifically, oxide semiconductors such as TiO₂, SnO, ZnO, WO₃, Nb₂O₅, In₂O₃, ZrO₂, Ta₂O₅ and TiSrO₃ are preferable. A porous titanium dioxide layer hardened by sintering is even further preferable.

Sulfide semiconductors such as CdS, ZnS, In₂S, PbS, Mo₂S, WS₂, Sb₂S₃, Bi₂S₃, ZnCdS₂ and CuS₂ may be used. Moreover, metal chalcogenide such as CdSe, ln₂Se₂, WSe₂, PbSe and CdTe are also applicable.

Even further, elemental semiconductors such as GaAs, Si, Se and InP may be used.

Further, a composite of two or more substances described above, such as a composite of SnO and ZnO or a composite of TiO₂ and Nb₂O₅, may also be used.

The varieties of semiconductors are not restricted to those described above, and a mixture of two or more substances may also be used.

The thickness of the second photovoltaic layer 16 in the height direction should preferably be 3 - 30 µm, and more preferably, 6 - 20 µm.

Further, the above-described second photovoltaic layer 16 may carry sensitized dye. Various dyes that exert sensitization can be applied as the dye carried by the second photovoltaic layer 16, and for example, N3 complex, N719 complex (N719 dye), Ru complex such as Ru terpyridine complex (black dye) and Ru diketonate complex, organic dyes such as coumarin dye, merocyanine dye and polyene dye, metal porphyrin dye and phthalocyanine dye are applicable. Among these dyes, the Ru complex is preferable, and specifically, N719 dye and black dye are especially preferable since they exert a wide absorption spectrum in the visible light range.

The dye can be used alone, or two or more dyes can be used in a mixture.

The above-described matters are common to the first, second and third embodiments and FIGs. 1, 2 and 4. In the following description, matters common to the first to third embodiments but have different reference numbers assigned in the drawings will be described by referring to the different reference numbers in the drawings.

A first conductive film (14 in FIGs. 1 and 2; 22 in FIG. 4) is formed on an upper surface of the first substrate 12. The first conductive film is preferably FTO (fluorine-doped tin oxide), but other than the FTO layer, for example, an indium - tin complex oxide (ITO) may be used.

A charge exchange layer (15 in FIGs. 1 and 2; 23 in FIG. 4) is formed on the first conductive film. A platinum (Pt) film is preferable as the charge exchange layer, but carbon electrode and conductive polymer may also be used instead of the platinum (Pt) film.

A first photovoltaic layer (21 in FIG. 1; 17 in FIG. 2; 24 in FIG. 4) is formed on the charge exchange layer.

In any of the first to third embodiments, a first photovoltaic layer is composed by dispersing silicon dioxide particles 10 as a first photovoltaic layer (21 in FIG. 1; 17 in FIG. 2; 24 in FIG. 4) on the charge exchange layer (15 in FIGs. 1 and 2; 23 in FIG. 4).

The silicon dioxide particles 10 that constitute the first photovoltaic layer (21 in FIG. 1; 17 in FIG. 2; 24 in FIG. 4) use glass particles formed for example of synthetic quartz, fused quartz glass, soda-lime glass, non-alkali glass or borosilicate glass, which are immersed in a solution of 5 - 10 % hydrofluoric acid or hydrochloric acid, washed with water and dried, and pulverized so that a major axis L of the particles is 20 to 100 nm. The first to third embodiments use synthetic quartz particles, which are crystalline of silicon dioxide, which are immersed in 10 % hydrofluoric solution, washed with water and dried, and pulverized so that a major axis L of the particles is 20 - 100 nm.

Electrolyte 19 is enclosed between the first photovoltaic layer (21 in FIG. 1; 17 in FIG. 2; 24 in FIG. 4) and the second photovoltaic layer 16, in a space that is surrounded by a sealing member 18 on four sides. The electrolyte 19 is used in the prior-art dye-sensitized solar cells, and it can be of any of the following states; liquid, solid, coagulated and ordinary temperature molten salt.

The electrolyte can be, for example, a combination of metal iodide, such as lithium iodide, sodium iodide, potassium iodide and cesium iodide, and iodine; a combination of iodine salt of quaternary ammonium compound, such as tetraalkylammonium iodide, pyridinium iodide and imidazolium iodide, and iodine; a combination of bromine compound - bromine instead of the aforementioned iodine and iodine compound; or a combination of cobalt complex.

If the electrolyte is an ionic liquid, there is no need to use a solvent. The electrolyte may be a gel electrolyte, a high polymer electrolyte or a solid electrolyte, and an organic charge transport material may be used instead of the electrolyte.

If the electrolyte 19 is in a state of a solution, the solvent may be, for example, nitrile-based solvent such as acetonitrile, metoxyacetonitrile and propionitrile, carbonate-based solvent such as ethylene carbonate, and ether-based solvent.

Specifically, the electrolyte 19 used in the first to third embodiments is formed by adding 0.1 mol Lil, 0.05 mol I₂, 0.5 mol 4-tetra-butylpyridine and 0.5 mol tetrabutylammonium iodide in acetonitrile solvent.

The distance between the first photovoltaic layer (21 in FIG. 1; 17 in FIG. 2; 24 in FIG. 4) and the second photovoltaic layer 16 in the height direction should preferably be as short as possible, since transfer of charge becomes easier if the distance is shorter.

In the first to third embodiments, the thickness of the electrolyte 19 portion in the height direction, that is, the distance between the first photovoltaic layer (21 in FIG. 1; 17 in FIG. 2; 24 in FIG. 4) and the second photovoltaic layer 16 in the height direction, is 200 µm or smaller.

Method for evaluating the maximum output value per unit area according to the present specification is as described below.

An LED light (manufactured by Cosmotechno Co., Ltd.) was used to irradiate light from the second substrate side, and light corresponding to 1000 lux by illuminometer DT-1309 manufactured by CEM Corporation was irradiated to the photovoltaic element being the target for measurement. A digital multimeter was used to measure the I-V characteristics of the photovoltaic element as the target for measurement, by which values of short circuit current, open circuit voltage and form factor ff were acquired, and the maximum output value per unit area was derived.

Hereafter, characteristics of the present embodiments will be described with reference to the drawings. The other portions are similar to the description regarding the matters common to the first to third embodiments described above.

### First Embodiment (not forming part of the claimed invention)

FIG. 1 is a view illustrating a first embodiment, not forming part of the claimed invention. In the first embodiment, silicon dioxide particles having an average major axis L of 20 - 100 nm are used as the silicon dioxide particles 10 used in the first photovoltaic layer 21. These silicon dioxide particles 10 are dispersed in an overlapped manner on a flat first conductive film 14 (FTO layer) and a similarly flat charge exchange layer 15 (Pt layer) formed thereon, by which the first photovoltaic layer 21 having a thickness of 300 to 500 nm in the height direction is composed.

Other conditions are as described as matters common to the first to third embodiments.

As a result, the embodiment realizes a significant improvement of photovoltaic efficiency compared to the prior art example described in the background art.

| | L | t | FTO layer roughness | Maximum output per unit area |
|---|---|---|---|---|
| Prior Art | 500~800nm | 0.15~0.20mm | Very little surface height difference | 28.00µW/cm² |
| First Embodiment | 20~100nm | 300~500nm | Very little surface height difference | 35.00µW/cm² |

| | | | | |
|---|---|---|---|---|
| L: Average major axis of silicon dioxide particles t: Silicon dioxide layer thickness | | | | |

In the first embodiment, the average major axis of the silicon dioxide particles 10 is small compared to the prior art, which is considered effective in increasing the surface area of the silicon dioxide particles 10 in the first photovoltaic layer 21 and raising the photovoltaic efficiency.

### Second Embodiment (claimed invention)

FIG. 2 is a view illustrating a second embodiment. The second embodiment uses the same materials and the like used in the first embodiment. However, in the second embodiment, a first photovoltaic layer 17 is composed so that the silicon dioxide particles 10 are arranged on a flat first conductive film 14 and a similarly flat charge exchange layer 15 disposed thereon, so that the thickness thereof in the height direction is 300 nm or smaller.

That is, the thickness of the first photovoltaic layer in the height direction is reduced compared to the first embodiment.

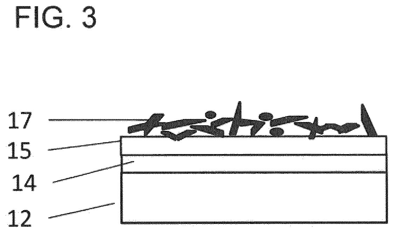

FIG. 3 is an enlarged view of portion A of FIG. 2, wherein the silicon dioxide particles 10 constituting the first photovoltaic layer 17 are dispersed on the flat first conductive film 14 (FTO layer) and the similarly flat charge exchange layer 14 (Pt layer) formed thereon, in a state where there is small overlap of particles.

As a result, the embodiment realizes a significant improvement of photovoltaic efficiency compared to the prior art example described in the background art.

| | L | t | FTO layer roughness | Maximum output per unit area |
|---|---|---|---|---|
| Prior Art | 500~800nm | 0.15~0.20mm | Very little surface height difference | 28.00µW/cm² |
| Second Embodiment | 20~100nm | 300nm or less | Very little surface height difference | 45.48µW/cm² |

| | | | | |
|---|---|---|---|---|
| L: Average major axis of silicon dioxide particles t: Silicon dioxide layer thickness | | | | |

In the second embodiment, the overlapping of the silicon dioxide particles 10 in the first photovoltaic layer 17 is reduced, according to which the property of charge transfer near the first photovoltaic layer 17 is enhanced, by which the photovoltaic efficiency is considered to be increased.

Therefore, it is important not to arrange too much silicon dioxide particles 10 on the upper surface of the charge exchange layer 15 in order to improve the photovoltaic efficiency. That is, it has been confirmed that the photovoltaic amount is increased if the silicon dioxide particles 10 are not excessively overlapped and sufficient space is formed therebetween.

Therefore, the thickness of the first photovoltaic layer 17 in the height direction is equal to or smaller than three times the average major axis L of the silicon dioxide particles.

The silicon dioxide particles 10 should preferably be arranged on the surface of an upper layer of the charge exchange layer 15 in a dispersed manner with spaces formed therebetween. This arrangement is to prevent the silicon dioxide particles 10 from being arranged in an overcrowded manner and hindering conductivity between the charge exchange layer 15, the silicon dioxide particles 10 and the electrolyte 19. It is preferable that the charge exchange layer 15, the silicon dioxide particles 10 and the electrolyte 19 are arranged with sufficient allowance, so that the total sum of contact surface areas of the charge exchange layer 15, the silicon dioxide particles 10 and the electrolyte 19 that perform charge exchange is maximized.

Therefore, the photovoltaic amount can be increased by arranging the silicon dioxide particles 10 in the first photovoltaic layer 17 such that the charge exchange layer 15 is visible through the spaces between the silicon dioxide particles 10 when the first substrate 12 is viewed from the second substrate 11 side.

### Third Embodiment (claimed invention)

FIG. 4 is a view illustrating a third embodiment. The third embodiment uses the same materials and the like as the first embodiment. However, in the third embodiment, a first conductive film 22 (FTO layer) and a charge exchange layer 23 (Pt layer) that constitute a base on which the silicon dioxide particles 10 are arranged are not flat. As illustrated in FIG. 4, the first conductive film 22 has an uneven surface (roughness or asperity), with a height difference of approximately 50 nm formed on the surface. The charge exchange layer 23 formed on the first conductive film 22 also has a roughness on the surface, influenced by the height difference formed on the first conductive film 22.

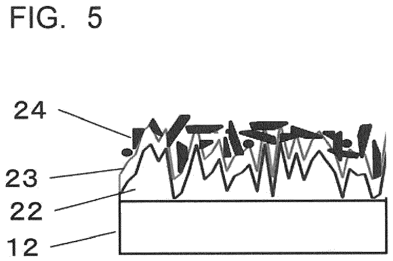

FIG. 5 is an enlarged view of portion B of FIG. 4. The silicon dioxide particles 10 constituting the first photovoltaic layer 24 are dispersed on the first conductive film 22 that has a roughness on the surface and the charge exchange layer 23 formed thereon and having a similar roughness, in a state where there is small overlap of particles.

The difference of height of the surface roughness of the first conductive film 22 should be 50 nm or greater, and more preferably, 100 nm or greater. Further, it is preferable that the charge exchange layer 23 formed on the first conductive film 22 is formed in a manner maintaining the shape of the roughness on the surface of the first conductive film 22 without burying the surface roughness of the first conductive film 22.

As a result, the embodiment realizes an even further significant improvement of photovoltaic efficiency compared to the prior art example described in the background art.

| | L | t | FTO layer roughness | Maximum output per unit area |
|---|---|---|---|---|
| Prior Art | 500~800nm | 0.15~0.20mm | Very little surface height difference | 28.00µW/cm² |
| Third Embodiment | 20~100nm | 300nm or less | Surface height difference approx. 50 nm | 70.8µW/cm² |

| | | | | |
|---|---|---|---|---|
| L: Average major axis of silicon dioxide particles t: Silicon dioxide layer thickness | | | | |

The arrangement of the silicon dioxide particles 10 dispersed on the charge exchange layer 23 formed on the first conductive film 22 is influenced by the surface roughness of the first conductive film 22 and charge exchange layer 23 as base layers.

Thanks to the surface roughness of the base layers, the silicon dioxide particles 10 are arranged in a thinly dispersed manner. Thereby, the silicon dioxide particles 10 are arranged with appropriate spatial allowance without excessive overlap, and therefore, the increase of photovoltaic amount is confirmed.

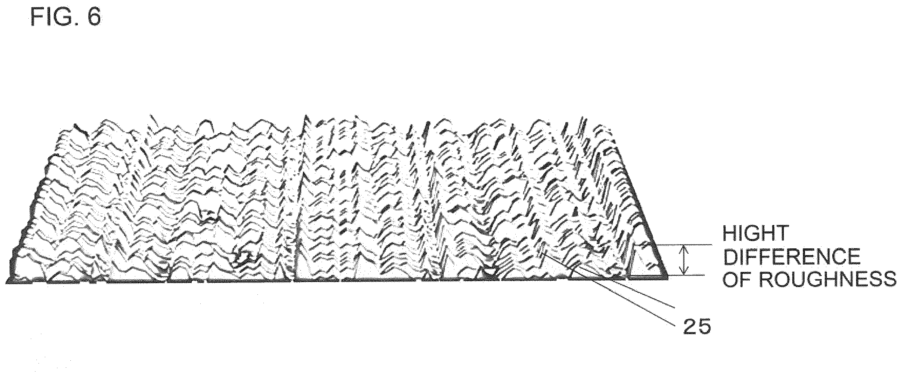

FIG. 6 is a schematic diagram in which the first conductive film 22 is illustrated from bird's eye view. The shape of the surface roughness of the first conductive film 22 is not only risen steeply, as illustrated in FIG. 5, but may also include a structure 25 where the surface is somewhat rounded, as illustrated in FIG. 6. Further, the roughness does not have to be random, as illustrated in FIGs. 5 and 6, and the roughness can be regularly arranged shapes, such as structural cones, trigonal pyramids, quadrangular pyramids and other pyramid shapes.

The present invention is not restricted to the above-described second and third embodiments, and various modifications are possible. For example, the optimum average major axis of the silicon dioxide particles 10 may vary according to the distribution of size and shape of the silicon dioxide particles 10 constituting the first photovoltaic layer. Similarly, the optimum value of thickness of the first conductive film in the height direction may vary according to the distribution of size and shape of the silicon dioxide particles 10.

Further, various optimum combinations of height difference of unevenness in the height direction of the first conductive film and/or the charge exchange layer, the shape of the roughness, and the distribution of the roughness in a direction parallel to the first substrate may be adopted in response to the distribution of size and shape of the silicon dioxide particles 10.

Of course, a portion of the respective embodiments may be added to, deleted from or replaced with other materials and configurations.

### [Reference Signs List]

- 10: silicon dioxide particle
- 11: second substrate
- 12: first substrate
- 13: second conductive film
- 14: first conductive film
- 15: charge exchange layer
- 16: second photovoltaic layer
- 17: first photovoltaic layer
- 18: sealing member
- 19: electrolyte
- 21: first photovoltaic layer
- 22: first conductive film
- 23: charge exchange layer
- 24: first photovoltaic layer

## Claims

1. A photovoltaic element comprising a first photovoltaic layer (17, 24),
wherein the first photovoltaic layer (17, 24) is composed of a silicon dioxide particle (10) that has an average major axis of 100 nm or smaller, and **characterized in that**
a thickness of the first photovoltaic layer (17, 24) in a height direction is formed to be equal to or smaller than three times an average major axis of the silicon dioxide particle (10).

2. A photovoltaic element according to claim 1, further comprising:
a first substrate (12) comprising a first conductive film (14) on one surface and a second substrate (11) comprising a second conductive film (13) on one surface are arranged such that the first conductive film (14) and the second conductive film (13) face each other;
a second photovoltaic layer (16) arranged on the second conductive film (13);
a charge exchange layer (15) arranged on the first conductive film (14);
the first photovoltaic layer (17, 24) being arranged on the charge exchange layer (15); and
an electrolyte (19) arranged between the second photovoltaic layer (16) and the first photovoltaic layer (17, 24).

3. The photovoltaic element according to claim 1 or 2,
wherein when the first substrate (12) is viewed from the second substrate side, the silicon dioxide particle (10) in the first photovoltaic layer (17, 24) is arranged such that the charge exchange layer (15) is visible through a gap formed between the silicon dioxide particles (10).

4. The photovoltaic element according to any one of claims 1 to 3,
wherein the charge exchange layer (15) and or the first conductive film (14) has a roughness of 50 nm or greater in the height direction.

5. The photovoltaic element according to any one of claims 1 to 4,
wherein the silicon dioxide particle (10) is silicon dioxide immersed in hydrogen halide.

6. The photovoltaic element according to any one of claims 2 to 5,
wherein the second photovoltaic layer (16) is a substance selected from TiO₂, SnO, ZnO, WO₃, Nb₂O₅, In₂O₃, ZrO₂, Ta₂O₅ and TiSrO₃.

7. The photovoltaic element according to any one of claims 2 to 6,
wherein the second photovoltaic layer (16) comprises sensitized dye carried thereon.

## Patentansprüche

1. Photovoltaisches Element, umfassend eine erste photovoltaische Schicht (17,24),
welche erste photovoltaische Schicht (17,24) aus einem Siliziumdioxid-Partikel (10) zusammengesetzt ist, der eine durchschnittliche Hauptachse von 100 nm oder kleiner aufweist, **dadurch gekennzeichnet, dass** eine Dicke der ersten photovoltaischen Schicht (17,24) in einer Höhenrichtung derart ausgebildet ist, dass sie gleich oder kleiner ist als das Dreifache einer durchschnittlichen Hauptachse des Siliziumdioxid-Partikels (10).

2. Photovoltaisches Element gemäß Anspruch 1, ferner umfassend:
ein erstes Substrat (12), umfassend einen ersten leitfähigen Film (14) auf einer Oberfläche, und ein zweites Substrat (11), umfassend einen zweiten leitfähigen Film (13) auf einer Oberfläche, welche derart angeordnet sind, dass der erste leitfähige Film (14) und der zweite leitfähige Film (13) einander zugewandt sind;
eine zweite photovoltaische Schicht (16), die auf dem zweiten leitfähigen Film (13) angeordnet ist;
eine Ladungsaustauschschicht (15), die auf dem ersten leitfähigen Film (14) angeordnet ist;
wobei die erste photovoltaische Schicht (17,24) auf der Ladungsaustauschschicht (15) angeordnet ist; und
ein Elektrolyt (19) zwischen der zweiten photovoltaischen Schicht (16) und der ersten photovoltaischen Schicht (17,24) angeordnet ist.

3. Photovoltaisches Element gemäß Anspruch 1 oder 2,
bei welchem dann, wenn das erste Substrat (12) von der zweiten Substratseite her betrachtet wird, der Siliziumdioxid-Partikel (10) in der ersten photovoltaischen Schicht (17,24) derart angeordnet ist, dass die Ladungsaustauschschicht (15) durch einen Zwischenraum zwischen den Siliziumdioxid-Partikeln sichtbar ist.

4. Photovoltaisches Element gemäß einem der Ansprüche 1 bis 3,
bei welchem die Ladungsaustauschschicht (15) und/oder der erste leitfähige Film (14) eine Rauheit von 50 nm oder größer in der Höhenrichtung aufweisen.

5. Photovoltaisches Element gemäß einem der Ansprüche 1 bis 4,
bei welchem der Siliziumdioxid-Partikel (10) Siliziumdioxid ist, welches in HalogenWasserstoff eingetaucht ist.

6. Photovoltaisches Element gemäß einem der Ansprüche 2 bis 5,
bei welchem die zweite photovoltaische Schicht (16) eine Substanz ist, ausgewählt aus TiO₂, SnO, ZnO, WO₃, Nb₂O₅, In₂O₃, ZrO₂, Ta₂O₅ und TiSrO₃.

7. Photovoltaisches Element gemäß einem der Ansprüche 3 bis 6,
bei welchem die zweite photovoltaische Schicht (16) einen darauf angebrachten sensibilisierten Farbstoff umfasst.

## Revendications

1. Élément photovoltaïque comprenant une première couche photovoltaïque (17, 24),
dans lequel la première couche photovoltaïque (17, 24) est composée d'une particule de dioxyde de silicium (10) qui a un grand axe moyen de 100 nm ou moins, et
**caractérisé en ce que**
une épaisseur de la première couche photovoltaïque (17, 24) dans la direction de la hauteur est formée de façon à être égale ou inférieure à trois fois un grand axe moyen de la particule de dioxyde de silicium (10).

2. Élément photovoltaïque selon la revendication 1, comprenant en outre :
un premier substrat (12) comprenant un premier film conducteur (14) sur une surface et un deuxième substrat (11) comprenant un deuxième film conducteur (13) sur une surface qui sont agencés de sorte que le premier film conducteur (14) et le deuxième film conducteur (13) se fassent mutuellement face ;
une deuxième couche photovoltaïque (16) agencée sur le deuxième film conducteur (13) ;
une couche d'échange de charge (15) agencée sur le premier film conducteur (14) ;
la première couche photovoltaïque (17, 24) étant agencée sur la couche d'échange de charge (15) ; et
un électrolyte (19) agencé entre la deuxième couche photovoltaïque (16) et la première couche photovoltaïque (17, 24).

3. Élément photovoltaïque selon la revendication 1 ou 2, dans lequel, lorsque le premier substrat (12) est observé depuis le côté du deuxième substrat, la particule de dioxyde de silicium (10) dans la première couche photovoltaïque (17, 24) est agencée de sorte que la couche d'échange de charge (15) est visible à travers un espacement formé entre les particules de dioxyde de silicium (10).

4. Élément photovoltaïque selon l'une quelconque des revendications 1 à 3,
dans lequel la couche d'échange de charge (15) et/ou le premier film conducteur (14) a une rugosité de 50 nm ou plus dans la direction de la hauteur.

5. Élément photovoltaïque selon l'une quelconque des revendications 1 à 4,
dans lequel la particule de dioxyde de silicium (10) est du dioxyde de silicium immergé dans un halogénure d'hydrogène.

6. Élément photovoltaïque selon l'une quelconque des revendications 2 à 5,
dans lequel la deuxième couche photovoltaïque (16) est une substance choisie parmi TiO₂, SnO, ZnO, WO₃, Nb₂O₅, In₂O₃, ZrO₂, Ta₂O₅ et TiSrO₃.

7. Élément photovoltaïque selon l'une quelconque des revendications 2 à 6,
dans lequel la deuxième couche photovoltaïque (16) comprend un colorant sensibilisé porté sur celle-ci.
